# EUROPÄISCHE PATENTSCHRIFT

(11) **EP 1 421 341 B1**
(45) Veröffentlichungstag und Bekanntmachung des Hinweises auf die Patenterteilung: **09.02.2011**
(21) Anmeldenummer: 02797618.2
(22) Anmeldetag: 24.08.2002
(51) Int. Cl.: G01D 5/347, H03K 17/968

(54) **VORRICHTUNG ZUM OPTOELEKTRONISCHEN ERFASSEN VON SCHALTSTELLUNGEN EINES SCHALTMITTELS**
DEVICE FOR THE OPTOELECTRONIC DETECTION OF SWITCHING POSITIONS OF A SWITCHING ELEMENT
DISPOSITIF DE DETECTION OPTOELECTRONIQUE DE POSITIONS DE COMMUTATION D'UN ELEMENT DE COMMUTATION

(30) Priorität: 28.08.2001 DE 10141975
(43) Veröffentlichungstag der Anmeldung: 26.05.2004
(73) Patentinhaber: Leopold Kostal GmbH & Co. KG, 58507 Lüdenscheid (DE)
(72) Erfinder: BOEHNE, Gregor, 44575 Castrop-Rauxel (DE)
(86) Internationale Anmeldenummer: PCT/EP2002/009485
(87) Internationale Veröffentlichungsnummer: WO 2003/021196

(56) Entgegenhaltungen:
- DE-A- 2 849 934
- DE-A- 3 936 434
- DE-U- 8 522 868
- GB-A- 1 453 298
- RU-C- 2 029 428
- US-A- 3 946 225
- US-A- 4 856 785
- US-A- 5 062 214

## Beschreibung

Die Erfindung betrifft eine Vorrichtung zum optoelektronischen Erfassen von Schaltstellungen eines mechanisch betätigbaren, zwangsgeführten Schaltmittels, und betrifft insbesondere eine solche umfassend einzelne photoelektrische Empfänger, wenigstens eine zum Belichten der Empfänger angeordnete Lichtquelle und eine Blende, wobei die Anordnung bestehend aus Lichtquelle und Empfängern relativ zur Blende bewegbar ist und das bewegliche Element an die Bewegung des Schaltmittels gekoppelt ist.

Vorrichtungen zum Erfassen von Schaltstellungen werden etwa bei Schaltern verwendet, denen mehrere Funktionen zukommen, um für einen Benutzer erkennbar zu machen, in welcher Schalt- bzw. Schalterstellung sich ein solcher Multifunktionsschalter befindet. Derartige Schalter werden beispielsweise als Beleuchtungs- oder Lenkstockschalter in Kraftfahrzeugen eingesetzt. Damit die Vielzahl der Funktionen unabhängig voneinander und parallel zueinander ausgeführt werden können, werden solche Schalter in mehreren Ebenen bewegbar ausgestaltet. Zur Darstellung der jeweiligen Schalterstellung können dem Schalter hinterleuchtete Symbole zugeordnet sein, wobei in Abhängigkeit von der jeweiligen Schalterstellung das oder die Symbole hinterleuchtet sind, die für die tatsächlich eingeschaltete Funktionen stehen.

Derartige Schalter sind herkömmlich als Kontaktschalter ausgelegt, so daß eine Schalterstellung dann erreicht ist, wenn durch das Schaltorgan die entsprechende elektrische Verbindung hergestellt ist. Auch wenn mit einem solchen Multifunktionsschalter eine Vielzahl unterschiedlicher Funktionen schaltbar sind, so erhöht sich der Aufwand bei komplizierten Schalterstrukturen unverhältnismäßig, wenn die jeweiligen Schalterstellungen auf die oben beschriebene Weise erfaßt werden sollen. Im übrigen unterliegen die für eine mechanische Kontaktierung vorgesehenen Elemente einem Verschleiß und Alterungserscheinungen.

Dabei kann eine Schaltstellungserfassung nicht nur dazu dienen, diese einem Benutzer erkennbar zu machen, sondern die jeweilige Schaltstellung soll auch als Dateneingang einer Datenverarbeitungsanlage, etwa einem Bordcomputer bei Kraftfahrzeugen für Überwachungs- und Steuerungszwecke zugänglich gemacht werden.

Multifunktionsschalter können, wie aus DE 43 32 748 A1 bekannt, als kontaktlose optoelektronisch arbeitende Schalter ausgebildet sein. Der in diesem Dokument beschriebene Schalter zeichnet sich dadurch aus, daß zur Erfassung einer Schaltstellung keine elektrische Kontaktierung herbeigeführt werden muß, sondern daß ein photosensitives Element als Empfänger lichtbeaufschlagt ist, wenn sich das Schaltmittel in einer bestimmten Schaltposition befindet. Ein solcher optischer Schalter umfaßt neben dem photosensitiven Element eine Lichtquelle, die beispielsweise auf derselben Platine wie das photosensitive Element angeordnet sein kann. Mittels eines Lichtleitkörpers, dessen lichtauskoppelseitige Fläche zur photosensitiven Oberfläche des photoelektrischen Elementes weisend angeordnet ist, wird das benötigte Licht zu dem photoelektrischen Element gebracht. Zwischen der Auskoppelseite des Lichtleitkörpers und dem photoelektrischen Element ist ein Bewegungsspalt vorgesehen, in dem eine an die Bewegung des Schaltmittels gekoppelte Blende bewegbar ist. Die Blende weist an vorgegebener Position eine Durchbrechung auf, so daß nach einem Bewegen des Schaltmittels in eine bestimmte Schaltstellung die Durchbrechung mit der auskoppelseitigen Fläche des Lichtleitkörpers und der photosensitiven Oberfläche des photoelektrischen Elementes fluchtet, so daß letzteres lichtbeaufschlagbar ist. Wird das Schaltmittel aus dieser Position wieder heraus bewegt, ist das photoelektrische Element abgeschattet und die Schaltstellung verlassen. Jede Schaltstellung ist beim Gegenstand dieses Dokumentes somit durch einen eigenen optoelektronischen Schalter realisiert. Durch entsprechendes Anordnen mehrerer derartiger optischer Schalter lassen sich auch komplizierte Schaltbewegungen erfassen. Bei beengten Einbauraumverhältnissen ist es jedoch mitunter nicht möglich, komplizierte Schaltbewegungen auf die beschriebene Art und Weise zu realisieren.

Aus DE 298 17 668 U1 ist eine weitere Schaltstellungserfassungsvorrichtung bekannt geworden, die optoelektronisch arbeitend ausgelegt ist. Beim Gegenstand dieses Dokumentes ist eine Lichtquelle an die Bewegung des Schaltmittels gekoppelt und wird somit mit dieser bei einer Bewegung mitgeführt. Die Lichtquelle beaufschlagt ein zweidimensionales Sensorarray, gebildet aus einer Vielzahl einzelner Wandlerelemente, beispielsweise einen Kamerasensor. In Abhängigkeit davon, welche Wandlerelemente des Sensorarrays in Abhängigkeit von der Stellung des Schaltmittels lichtbeaufschlagt sind, erfolgt eine Schaltstellungserkennung. Diese vorbekannte Schaltstellungserfassungseinrichtung benötigt jedoch zu ihrer Auswertung einen Mikroprozessor und ist daher aufwendiger als die zuvor beschriebene.

Ausgehend von diesem diskutierten Stand der Technik liegt der Erfindung daher die Aufgabe zugrunde, eine eingangs genannte gattungsgemäße Schaltstellungserfassungsvorrichtung dergestalt weiter zu bilden, daß diese nicht nur mit einfachen Mitteln realisierbar ist, sondern ebenfalls die zum vorbekannten Stand der Technik aufgezeigten Nachteile vermieden sind.

Diese Aufgabe wird erfindungsgemäß dadurch gelöst, daß zumindest zwei Empfänger in Schaltrichtung des Schaltmittels jeweils mindestens einen Schaltschritt entsprechend voneinander beabstandet angeordnet sind und daß die Blende einen Abschattungsbereich aufweist, durch den bei einem Wechsel der Schaltstellung zu einer benachbarten Schaltstellung des Schaltmittels sich jeweils nur der Zustand eines einzigen Empfängers ändert.

Ferner wird diese Erfindung durch eine Vorrichtung zum optoelektronischen Erfassen von Schaltstellungen eines mechanisch betätigbaren, zwangsgeführten Schaltmittels, umfassend einen photoelektrischen Empfänger, wenigstens mehrere zum Belichten des Empfängers angeordnete Lichtquellen und eine Blende, wobei die Anordnung bestehend aus Lichtquellen und Empfänger relativ zur Blende bewegbar ist und das bewegliche Element an die Bewegung des Schaltmittes gekoppelt ist, wobei zumindest zwei Lichtquellen in Schaltrichtung des Schaltmittels jeweils mindestens einen Schaltschritt entsprechend voneinander beabstandet angeordnet sind und wobei die Blende einen Abschattungsbereich aufweist, durch den bei einem Wechsel der Schaltstellung zu einer benachbarten Schaltstellung des Schaltmittels jeweils nur eine einzige Lichtquelle ihren Zustand im Hinblick auf eine Belichtung des Empfängers ändert.

Bei der erfindungsgemäßen Schaltstellungserfassungseinrichtung entsprechend dem ersten Lösungsvorschlag ist im Gegensatz zum vorbekannten Stand der Technik vorgesehen, eine aus zumindest zwei Empfängern gebildete Empfängeranordnung sowie eine Blende mit einem Abschattungsbereich einzusetzen, die ausgebildet ist, daß bei einem Wechsel der Schaltstellungen jeweils nur ein Empfänger seinen Zustand ändert. Beispielsweise kann der Abschattungsbereich ausgestaltet so ausgestaltet sein, daß alle Empfänger gleichzeitig abgeschattet sind. Bei einer solchen Ausgestaltung sind bei Einsatz von zwei Empfängern grundsätzlich vier Schaltschritte detektierbar. Die zumindest zwei Empfänger sind in Schaltrichtung des Schaltmittels jeweils mindestens einen Schaltschritt entsprechend voneinander beabstandet angeordnet. Da die Blende einen Abschattungsbereich aufweist, mit dem ggf. beide Empfänger gleichzeitig abgeschattet werden können, wodurch eine Schaltstellung definiert ist, ist es ebenfalls möglich, sowohl nur den einen Empfänger als auch den anderen Empfänger oder auch keinen Empfänger abzuschatten, wodurch die drei weiteren Schaltstellungen bei einer solchen Ausgestaltung definiert sind. Bei Vorsehen von vier Schaltschritten sind, wenn eine Teilabschattung einzelner Empfänger nicht vorgesehen ist, lediglich zwei Empfänger notwendig, so daß die Zahl der eingesetzten Empfänger gegenüber der beim vorbekannten Stand der Technik notwendigen Empfängeranzahl um 50 % reduziert ist. Bei Vorsehen einer Teilabschattung kann sich die Zahl der benötigten Empfänger gegenüber dem vorbekannten Stand der Technik noch weiter reduzieren. Zur Vermeidung von Fehlinterpretationen ist beim Gegenstand der beanspruchten Schaltstellungserfassungsvorrichtung ferner vorgesehen, daß bei einem Wechsel der Schaltstellung zu einer benachbarten Schaltstellung des Schaltmittels jeweils nur ein einziger Empfänger seinen Zustand ändert. Diese Zustandsänderung kann hervorgerufen sein durch Belichten eines zuvor unbelichteten Empfängers oder umgekehrt, oder auch durch Ändern der Belichtungsintensität, beispielsweise durch eine bereichsweise Abschattung eines Empfängers durch die Blende.

Entsprechend dem zweiten Lösungsvorschlag ist die Schaltstellungserfassungseinrichtung ähnlich ausgebildet. Im Unterschied zu der zuvor beschriebenen Schaltstellungserfassungseinrichtung sind die Rollen von Lichtquelle und Empfänger vertauscht. Bei diesem zweiten Lösungsvorschlag sind zumindest zwei Lichtquellen vorgesehen und dem gegenüber nur ein einziger Empfänger. Das von den Lichtquellen emittierte Licht ist codiert, beispielsweise zeitlich getaktet. Über eine entsprechende Auswertung des empfangenen Signals ist eine Schaltstellung detektierbar. Eine Lichtcodierung kann beispielsweise auch über die Wellenlänge erfolgen, wobei unterschiedliche Lichtquellen Licht unterschiedlicher Wellenlänge emittieren.

Ohne weiteres eignet sich die erfindungsgemäße Schaltstellungserfassungsvorrichtung auch dazu, eine Schaltstellungserfassung durchzuführen, wenn das Schaltmittel in zwei oder mehr Richtungen bewegbar ist. In jeder Bewegungsrichtung des Schaltmittels ist eine aus zumindest zwei Empfängern bestehende Empfängeranordnung und die Blende mit ihrem Abschattungsbereich - beides wie oben beschrieben - konzipiert. Durch den verglichen mit dem vorbekannten Stand der Technik geringeren Hardwareeinsatz lassen sich mit einer solchen Schaltstellungserfassungsvorrichtung auch komplizierte Schaltbewegungen optoelektronisch detektieren, ohne daß dazu ein größerer Einbauraum notwendig wäre.

Zum Auswerten dieser Schaltstellungserfassungsvorrichtung ist der Einsatz eines Mikroprozessors grundsätzlich nicht notwendig. Die Auswertung kann über eine Digitalschaltung erfolgen, über die das Ausgangssignal unmittelbar an eine das Ausgangssignal der Schaltstellungserfassungsvorrichtung weiter verarbeitenden Einrichtung zugeführt wird. Beispielsweise kann eine solche digitale Schaltung ein Binärdekodierer sein.

Zweckmäßig zum Betrieb einer solchen Schaltstellungserfassungseinrichtung ist der Einsatz einer IR-Lichtquelle. Bei einer solchen Ausgestaltung ist den eingesetzten Empfängern jeweils ein IR-lichtdurchlassendes Filter vorgeschaltet, so daß die Schaltstellungserfassungsvorrichtung gegenüber ansonsten störendem Tageslicht nicht abgekapselt zu werden braucht.

Für den Fall, daß ein Mikroprozessor in der Umgebung der Schaltstellungserfassungsvorrichtung zur Verfügung steht, wie beispielsweise in einem Kraftfahrzeug, kann anstelle der eingesetzten diskreten photoelektrischen Empfänger auch ein aus einer Vielzahl einzelner photoelektrischer Empfänger aufgebautes Sensorarray, beispielsweise ein Zeilen- oder Kamerasensor eingesetzt sein.

Nachfolgend ist die Erfindung anhand von Ausführungsbeispielen unter Bezugnahme auf die beigefügten Figuren beschrieben. Es zeigen:
- **Fig. 1a-d:**: Eine schematische Darstellung einer optoelektronisch arbei- tenden Schaltstellungserfassungseinrichtung, mit der in einer Schaltrichtung vier Schaltstellungen realisierbar sind und
- **Fig. 2:**: Eine schematische Darstellung einer weiteren Schaltstel- lungserfassungseinrichtung, dessen Schaltmittel in zwei Richtungen bewegbar ist.

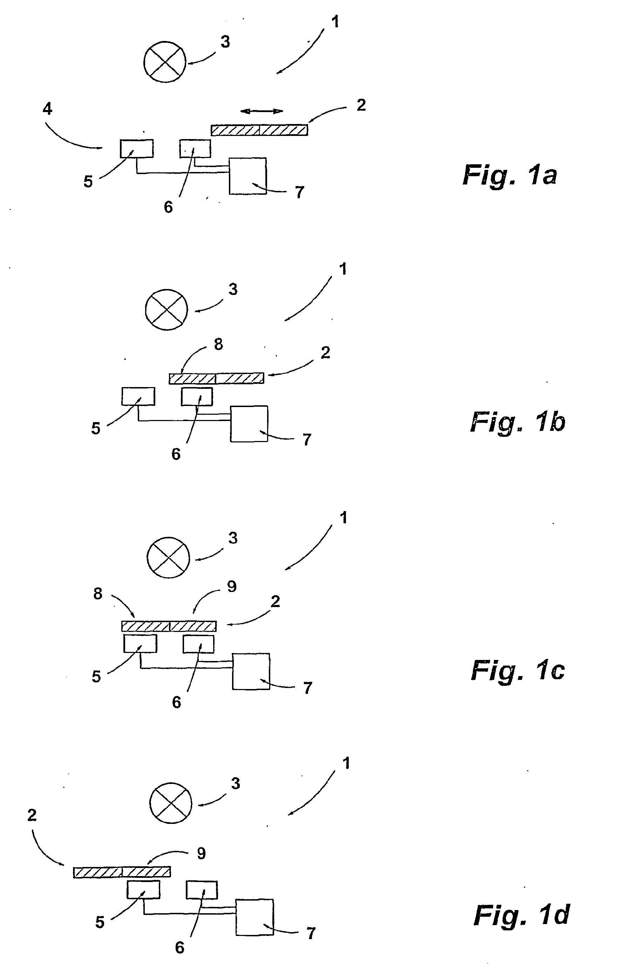

Figur 1a zeigt in einer schematisierten Darstellung eine Schaltstellungserfassungsvorrichtung 1, an dessen nicht dargestelltem Schaltmittel eine Blende 2 angeordnet ist. Die Blende 2 bildet in ihrer vollen, in Figur 1a gezeigten Breite einen Abschattungsbereich. Die Blende 2 ist an die Bewegung des Schaltsmittels gekoppelt und in der durch den Doppelpfeil gekennzeichnete Ebene verschiebbar. Die Darstellung der Bewegung der Blende 2 in einer Ebene dient der Vereinfachung der Darstellung. Tatsächlich ist das Schaltmittel um eine Drehachse schwenkbar angelenkt, so daß auch die Blende 2 auf einer Kreisbahn bewegt wird. Auf der einen Seite der Blende ist ortsfest zu dieser eine Lichtquelle 3 angeordnet, die in dem dargestellten Ausführungsbeispiel eine IR-Licht emittierende LED ist. Auf der anderen Seite der Blende 2 ist ebenfalls ortsfest zu der Blende 2 eine Empfängeranordnung 4 gebildet, die aus zwei diskreten photolelektrischen Empfängern 5, 6 besteht. Die Lichtquelle 3 und die Empfänger 5, 6 sind zweckmäßigerweise auf einer gemeinsamen Platine angeordnet. Die beiden Empfänger 5, 6 sind IR-empfindlich. Zum Unterdrücken von Tageslichtreflexen ist den Empfängern 5, 6 ein lediglich IR-lichtdurchlassendes Filter vorgeschaltet. Die Empfänger 5, 6 sind an eine mit dem Bezugszeichen 7 gekennzeichnete Auswerteschaltung angeschlossen.

Mit der Schaltstellungserfassungsvorrichtung 1 sind vier Schaltstellungen realisierbar, von denen in Figur 1a eine erste dargestellt ist: In dieser Schaltstellung sind beide Empfänger 5, 6 durch die Lichtquelle 3 belichtet. Die zweite Schaltstellung des Schaltmittels ist in Figur 1b gezeigt. In dieser Schaltstellung ist der Empfänger 6 durch den vorderen Teil 8 der Blende 2 abgeschattet, so daß diese Schaltstellung durch ein eine alleinige Belichtung des Empfängers 5 wiedergebendes Ausgangssignal gekennzeichnet ist. Figur 1c zeigt eine dritte Schaltstellung der Schaltstellungserfassungsvorrichtung 1, in der beide Empfänger 5, 6 gegenüber dem von der Lichtquelle 3 emittierten Licht abgeschattet sind. In dieser Stellung schattet der vordere Bereich 8 der Blende 2 den Empfänger 5 und der hintere Bereich 9 der Blende 2 den Empfänger 6 ab. Die vierte Schaltstellung ist in Figur 1d gezeigt, in der der hintere Bereich 9 der Blende 2 den Empfänger 5 abschattet, so daß das Ausgangssignal der Schaltstellungserfassungsvorrichtung lediglich eine Belichtung des Empfängers 6 wiederspiegelt.

In der gezeigten Schaltreihenfolge ist erkennbar, daß ein Stellungswechsel lediglich zur Änderung des Zustandes eines einzigen Empfängers 5 oder 6 führt. Auf diese Weise sind Fehlinterpretationen verhindert, die entstehen könnten, wenn zwei Empfänger nacheinander und nicht gleichzeitig ihren Zustand wechseln würden.

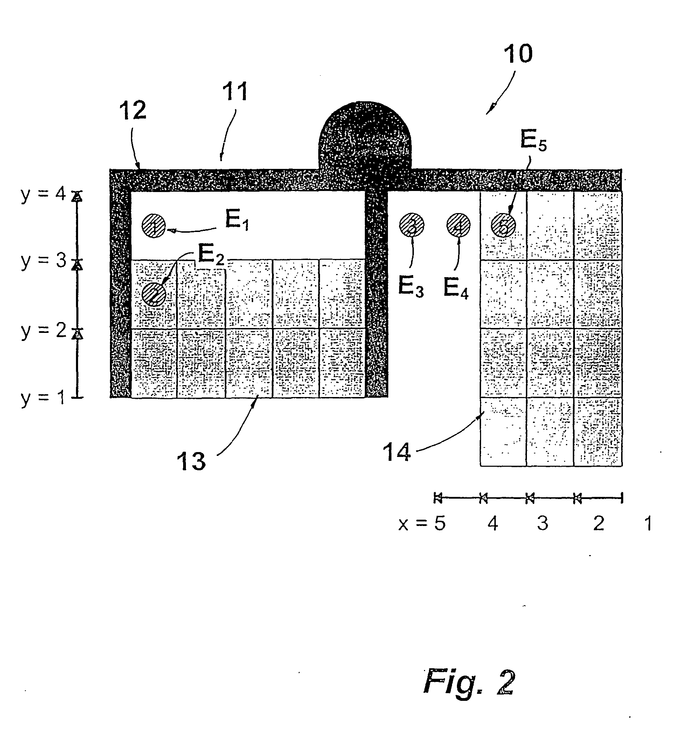

Figur 2 zeigt in einer schematisierten Darstellung eine weitere Schaltstellungserfassungsvorrichtung 10, die im Gegensatz zu der Schaltstellungserfassungsvorrichtung 1 der Figuren 1a - 1d eine Schaltstellungserfassung in zwei Richtungen ermöglicht. Das Schaltmittel der Schaltstellungserfassungsvorrichtung 10 ist um zwei Drehachsen schwenkbar gelagert. An die Bewegung des Schaltmittels gekoppelt ist eine Blende 11, aufgebaut bei dem dargestellten Ausführungsbeispiel aus einem Halter 12, der zwei Abschattungsstreifen 13, 14 trägt. Jeder Abschattungsbereich 13, 14 dient zur Schaltstellungserfassung jeweils einer Empfängeranordnung. Eine aus den Empfängern E₁ und E₂ aufgebaute Empfängeranordnung dient zur Schaltstellungserfassung einer Bewegung des Schaltmittels in y-Richtung. Die weitere Empfängeranordnung, aufgebaut aus den Empfängern E₃ - E₅ dient zum Erfassen einer Schaltstellung des Schaltmittels in x-Richtung. Die Empfänger E₁, E₂ bzw. E₃ - E₅ sind jeweils einen Schaltschritt entsprechend voneinander beabstandet. Die Abschattungsstreifen 13, 14 sind zur Verdeutlichung der unterschiedlichen Schaltpositionen des Schaltmittels in Kästchen unterteilt. In y-Richtung sind durch den Einsatz von zwei Empfängern E₁, E₂ vier Schaltstellungen erfaßbar. In x-Richtung durch den Einsatz von drei Empfängern E₃ - E₅ sind bei diesem Ausführungsbeispiel fünf Schaltstellungen erfaßbar. Die Zustände der einzelnen Empfänger E₁ - E₅ in den unterschiedlichen Schaltstellungen der Schaltstellungserfassungsvorrichtung 10 sind in der nachfolgenden Tabelle wiedergegeben:

| **y-Position** | **E₁** | **E₂** | **x-Position** | **E₃** | **E₄** | **E₅** |
|---|---|---|---|---|---|---|
| **1** | hell | dunkel | **1** | hell | hell | dunkel |
| **2** | dunkel | dunkel | **2** | hell | dunkel | dunkel |
| **3** | dunkel | hell | **3** | dunkel | dunkel | dunkel |
| **4** | hell | hell | **4** | dunkel | dunkel | hell |
| | | | **5** | dunkel | hell | hell |

Zur Detektion von sechs x-Schalterstellungen kann die beschriebene Anordnung derart modifiziert werden, daß der Abschattungsstreifen 13 sechs Kästchen breit ist. Die x=sechs-Position ist dann dadurch bestimmt, daß die Empfänger E₃ - E₅ belichtet sind.

Zur Vereinfachung der Darstellung der Blende 11 ist diese in eine Ebene abgewickelt in Figur 2 dargestellt. Tatsächlich ist diese gekrümmt, wobei sich der Krümmungsmittelpunkt im Schnittpunkt der beiden Drehachsen des Schaltmittels befindet. In unmittelbarer Nähe zu dem Schnittpunkt der Drehachsen des Schaltmittels ist ebenfalls die in Figur 2 nicht dargestellte Lichtquelle angeordnet.

Aus der Beschreibung der Erfindung wird deutlich, daß mit den beschriebenen Schaltstellungserfassungsvorrichtungen auch auf kleinstem Einbauraum und nur mit einem geringen Einsatz an Hardware eine Vielzahl von Schaltstellungen beispielsweise eines Lenkstockschalters eines Kraftfahrzeuges erfaßbar sind. Anstelle der in den Figuren gezeigten Anordnung, bei der die Blenden beweglich und die Empfänger und die Lichtquelle ortsfest angeordnet sind, kann ebenfalls vorgesehen sein, die Blende ortsfest und die anderen Elemente beweglich anzuordnen. Grundsätzlich ist es ebenfalls möglich, anstelle der eingesetzten diskreten Empfänger ein Sensorarray, beispielsweise ein Kamerasensor einzusetzen, auf dem diskrete Bereiche einer Schaltstellung zugeordnet sind.

Der in diesen Unterlagen benutzte Begriff Abschattung bzw. Abschattungsbereich umfaßt zum einen eine Anordnung, wie in den Figuren beschrieben, so daß durch einen solchen Abschattungsbereich eine direkte Abschattung erfolgt. Unter diesen Begriff ist jedoch auch eine solche Ausgestaltung zu verstehen, bei der auch Spiegel als Blende eingesetzt sind, so daß dann Lichtquelle und Empfänger auf der selben Seite zur Blende angeordnet sind und eine Belichtung eines Empfängers bei entsprechender Spiegeistellung erfolgt.

### Bezugszeichenliste

- 1: Schaltstellungserfassungsvorrichtung
- 2: Blende
- 3: Lichtquelle
- 4: Empfängeranordnung
- 5: Empfänger
- 6: Empfänger
- 7: Auswerteschaltung
- 8: Vorderer Bereich der Blende
- 9: Hinterer Bereich der Blende
- 10: Schaltstellungserfassungsvorrichtung
- 11: Blende
- 12: Halter
- 13: Abschattungsstreifen
- 14: Abschattungsstreifen

- E₁ - E₅: Empfänger

## Patentansprüche

1. Vorrichtung zum optoelektronischen Erfassen von Schaltstellungen eines mechanisch betätigbaren, zwangsgeführten Schaltmittels, umfassend einzelne photoelektrische Empfänger (5, 6; E₁ - E₅), wenigstens eine zum Belichten der Empfänger (5, 6; E₁ - E₅) angeordnete Lichtquelle (3) und eine Blende (2, 11), wobei die Anordnung bestehend aus Lichtquelle (3) und Empfängern (5, 6; E₁ - E₅) relativ zur Blende (2, 11) bewegbar ist und das bewegliche Element an die Bewegung des Schaltmittels gekoppelt ist, **dadurch gekennzeichnet, daß** zumindest zwei Empfänger (5, 6; E₁, E₂; E₃ - E₅) in Schaltrichtung des Schaltmittels jeweils mindestens einen Schaltschritt entsprechend voneinander beabstandet angeordnet sind und daß die Blende (2, 11) einen Abschattungsbereich (13, 14) aufweist, durch den bei einem Wechsel der Schaltstellung zu einer benachbarten Schaltstellung des Schaltmittels sich jeweils nur der Zustand eines einzigen Empfängers (5, 6; E₁ - E₅) ändert.

2. Vorrichtung zum optoelektronischen Erfassen von Schaltstellungen eines mechanisch betätigbaren, zwangsgeführten Schaltmittels, umfassend einen photoelektrischen Empfänger, wenigstens mehrere zum Belichten des Empfängers angeordnete Lichtquellen und eine Blende, wobei die Anordnung bestehend aus Lichtquellen und Empfänger relativ zur Blende bewegbar ist und das bewegliche Element an die Bewegung des Schaltmittels gekoppelt ist, wobei zumindest zwei Lichtquellen in Schaltrichtung des Schaltmittels jeweils mindestens einen Schaltschritt entsprechend voneinander beabstandet angeordnet sind und das von den Lichtquellen emittierte Licht codiert ist, und wobei die Blende einen Abschattungsbereich aufweist, durch den bei einem Wechsel der Schaltstellung zu einer benachbarten Schaltstellung des Schaltmittels jeweils nur der Zustand einer einzigen Lichtquelle im Hinblick auf eine Belichtung des Empfängers geändert wird.

3. Schaltstellungserfassungsvorrichtung nach Anspruch 1 oder 2, **dadurch gekennzeichnet, daß** das Schaltmittel in zwei oder mehr Richtungen bewegbar ist und in diesen Richtungen jeweils eine zur Realisierung der Schaltstellungen vorgesehene Empfängeranordnung bzw. Lichtquellenanordnung aufweist und der Abschattungsbereich (13, 14) der Blende (2, 11) entsprechend konzipiert ist.

4. Schaltstellungserfassunsvorrichtung nach einem der Ansprüche 1 bis 3, **dadurch gekennzeichnet, daß** das Schaltmittel um eine oder mehr Achsen drehbar gelagert ist, sich die Lichtquelle bzw. der Empfänger im Bereich des Schnittpunktes der Drehachsen befindet und die Blende (11) eine gekrümmte Oberfläche zumindest im Abschattungsbereich mit ihrem Krümmungsmittelpunkt in dem Schnittpunkt der Drehachsen aufweist.

5. Schaltstellungserfassungsvorrichtung nach einem der Ansprüche 1 bis 4, **dadurch gekennzeichnet, daß** als Lichtquelle (3) oder als Lichtquellen IR-Licht emittierende Lichtquellen eingesetzt ist und der bzw. die Empfänger IR-empfindlich sind und einen IR-Licht durchlassendes Filter umfassen.

6. Schaltstellungserfassungsvorrichtung nach einem der Ansprüche 1 oder 3 bis 5, **dadurch gekennzeichnet, daß** jeder Empfängeranordnung (4) eine Binärdekodierschaltung zur unmittelbaren Erzeugung eines digitalen Ausgangssignales zugeordnet ist.

7. Schaltstellungserfassungsvorrichtung nach einem der Ansprüche 1 oder 3 bis 5, **dadurch gekennzeichnet, daß** als Empfänger ein aus einer Vielzahl von einzelnen photoelektrischen Empfängern aufgebautes Sensorarray, etwa ein Kamerasensor eingesetzt ist.

## Claims

1. Device for the optoelectronic detection of switching positions on a mechanically operable, positively driven switching means which is made up of individual photoelectric receivers (5, 6; E₁ - E₅), at least one light source (3) that is arranged so as to expose the receivers (5, 6; E₁ - E₅), and an aperture (2, 11), with this arrangement consisting of light source (3) and receivers (5, 6; E₁ - E₅) being moveable in relation to the aperture (2, 11), and this moveable element being coupled to the movement of the switching means, **characterised in that** at least two receivers (5, 6; E₁, E₂; E₃ - E₅) are arranged in the switching direction of the switching means at a distance to one another corresponding to at least one switching step, and that the aperture (2, 11) has a shading section (13, 14) by way of which only the state of a single receiver (5, 6; E₁ - E₅) changes each time the switching position is altered to an adjacent switching position of the switching means.

2. Device for the optoelectronic detection of switching positions on a mechanically operable, positively driven switching means which is made up of a photoelectric receiver, at least several light sources that are arranged so as to expose the receiver, and an aperture, with this arrangement consisting of light sources and receivers being moveable in relation to the aperture, and this moveable element being coupled to the movement of the switching means, with at least two light sources arranged in the switching direction of the switching means at a distance to one another corresponding to at least one switching step, and the light emitted by the light sources being encoded, and with the aperture having a shading section by way of which only the state of a single light source changes each time the switching position is altered regarding an exposure of the receiver to an adjacent switching position of the switching means.

3. Switching position detection device in accordance with Claim 1 or Claim 2, **characterised in that** the switching means is moveable in two or more directions and has a receiver arrangement or light source arrangement provided in each of these directions for the purpose of achieving the switching positions, and the shading section (13, 14) of the aperture (2, 11) is designed accordingly.

4. Switching position detection device in accordance with any of Claims 1 to 3, **characterised in that** the switching means is rotatably mounted around one or more axes, the light source or the receiver, as the case may be, is located in the vicinity of the intersection of the rotary axes, and the aperture (11) has a curved surface at least in the shading section with the centre of curvature at the intersection of the rotary axes.

5. Switching position detection device in accordance with any of Claims 1 to 4, **characterised in that** light sources that emit IR light are implemented as the light source (3) or light sources and the receiver or receivers are IR sensitive and incorporate a filter that allows the transmission of IR light.

6. Switching position detection device in accordance with any of Claims 1 or 3 to 5, **characterised in that** a binary decoding circuit is allocated to each receiver arrangement (4) for the purpose of immediately generating a digital output signal.

7. Switching position detection device in accordance with any of Claims 1 or 3 to 5, **characterised in that** a sensor array, for instance a camera sensor, made up of a plurality of individual photoelectric receivers is implemented as a receiver.

## Revendications

1. Dispositif pour la saisie optoélectronique de positions de commutation d'un moyen de commutation à commande forcée, actionnable mécaniquement, qui comprend des récepteurs photoélectriques, individuels (5, 6 ; E₁ - E₅), au moins une source de lumière (3), qui est agencée pour l'exposition des récepteurs (5, 6 ; E₁ - E₅), et un diaphragme (2, 11), le circuit, qui comprend une source de lumière (3) et des récepteurs (5, 6 ; E₁ - E₅), étant déplaçable par rapport au diaphragme (2, 11) et l'élément mobile étant couplé au le mouvement du moyen de commutation, **caractérisé en ce que** deux récepteurs (5, 6; E₁; E_{2;} E₃ - E₅) au moins sont disposés, dans la direction de commutation du moyen de commutation, en étant respectivement, espacés l'un de l'autre d'un intervalle, qui correspond à au moins un pas de commutation, et que le diaphragme (2, 11) présente une zone d'ombre (13, 14) en raison de laquelle, lors d'un passage d'une position de commutation du moyen de commutation à une position de commutation voisine, uniquement l'état d'un seul récepteurs (5, 6 ; E₁ - E₅) est respectivement modifié

2. Dispositif pour la saisie optoélectronique de positions de commutation d'un moyen de commutation à commande forcée, actionnable mécaniquement, qui comprend un récepteur photoélectriques, au moins plusieurs sources de lumière, qui sont disposées pour éclairer le récepteur, et un diaphragme, le circuit, qui comprend sources de lumière et récepteur, étant déplaçable par rapport au diaphragme et l'élément mobile étant couplé au le mouvement du moyen de commutation, au moins deux sources de lumière étant disposées, dans la direction de commutation du moyen de commutation, en étant respectivement espacées l'une de l'autre d'un intervalle, qui correspond à au moins un pas de commutation, et la lumière émise par les sources de lumière étant codée, et le diaphragme présentant une zone d'ombre, en raison de laquelle, lors d'un passage d'une position de commutation du moyen de commutation à une position de commutation voisine, uniquement l'état d'une seule source de lumière est respectivement modifie en ce qui concerne une exposition du récepteur.

3. Dispositif pour la saisie de positions de commutation selon revendication 1 ou 2, **caractérisé en ce que** le moyen de commutation peut être déplacé dans deux ou plusieurs directions et présente dans chacune de ces directions un circuit de réception respectivement un circuit lumineux, prévu pour la réalisation des positions de commutation, et que la zone d'ombre (13, 14) du diaphragme (2, 11) est de conception adéquate.

4. Dispositif pour la saisie de positions de commutation selon l'une des revendications 1 à 3, **caractérisé en ce que** le moyen de commutation est monté à rotation sur un ou plusieurs axes, que la source de lumière, respectivement le récepteur est situé/e dans la zone du point d'intersection des axes de rotation et que le diaphragme (11) présente, au moins dans la zone d'ombre, une surface courbe, dont le centre de courbure est situé dans le point d'intersection des axes de rotation.

5. Dispositif pour la saisie de positions de commutation selon l'une des revendications 1 à 4, **caractérisé en ce que**, comme source de lumière (3) ou sources de lumières, on utilise des sources de lumière, qui émettent une lumière IR, et que le récepteur ou les récepteurs est / sont des récepteurs sensibles à la lumière IR et comprennent un filtre perméable à la lumière IR.

6. Dispositif pour la saisie de positions de commutation selon l'une des revendications 1 ou 3 à 5, **caractérisé en ce qu'**à chaque circuit de réception (4) est associé un circuit de décodage binaire pour générer directement un signal de sortie numérique.

7. Dispositif pour la saisie de positions de commutation selon l'une des revendications 1 ou 3 à 5, **caractérisé en ce que** le récepteur utilisé est un réseau de capteurs, qui est composé de nombreux récepteurs photoélectriques, individuels, tel qu'un capteur de caméra.
